Europäisches Patentamt

(19) European Patent Office

Office européen des brevets

(11) Veröffentlichungsnummer: **0 020 998**
B1

# (12) EUROPÄISCHE PATENTSCHRIFT

(45) Veröffentlichungstag der Patentschrift:
13.04.83

(21) Anmeldenummer: 80102657.6

(22) Anmeldetag: 13.05.80

(51) Int. Cl.³: **H 01 L 21/00, H 01 L 27/06**

(54) Verfahren zum Herstellen eines bipolaren Transistors mit ionenimplantierter Emitterzone.

(30) Priorität: 22.06.79 US 51078

(43) Veröffentlichungstag der Anmeldung:
07.01.81 Patentblatt 81/1

(45) Bekanntmachung des Hinweises auf die Patenterteilung:
13.04.83 Patentblatt 83/15

(84) Benannte Vertragsstaaten:
DE FR GB

(56) Entgegenhaltungen:
FR-A-1 544 067
FR-A-2 279 223
US-A-3 468 728
US-A-3 474 021
US-A-3 933 528
US-A-4 110 125
US-A-4 118 250
IBM TECHNICAL DISCLOSURE BULLETIN, vol. 14, April 1972, Nr. 11, New York, USA C. W. SCHEFFER und L. L. WU: »SCOTTKY barrier diode clamp farbrication«, Seite 3410.
INSTITUTE OF ELECTRICAL AND ELECTRONICS ENGINEERS INTERNATIONAL ELECTRON DEVICES MEETING, technical digest, Dezember 6—8, 1976, New York, USA A. AITKEN et al. »A

(73) Patentinhaber: International Business Machines Corporation, Armonk, N.Y. 10504 (US)

(72) Erfinder: Barile, Conrad Aibert, 14 Alpert Drive, Wappingers Falls, New York 12590 (US)
Erfinder: Goth, George Richard, RD No.2 Todd Hill Road, Poughkeepsie, New York 12603 (US)
Erfinder: Makris, James Steve, 28 Hili Top Drive, Wappingers Falls, New York 12590 (US)
Erfinder: Nagarajan, Arunachala, 2 Namoth Road, Wappingers Falls, New York 12590 (US)
Erfinder: Raheja, Raj Kanwal, RD No-1, Cottage Road, Hopewell Junction, New York 12533 (US)

(74) Vertreter: Gaugel, Heinz, Dipl.-Ing., Schönaicher Strasse 220, D-7030 Böblingen (DE)

fully plasma etched-ion implanted CMOS process«, Seiten 209—213.
IBM TECHNICAL DISCLOSURE BULLETIN, vol. 20, April 1978, Nr. 11A, New York, USA C. A. BARILE et al. »Ion implanting an emitter«, Seiten 4351—4352.

## Verfahren zum Herstellen eines bipolaren Transistors mit ionenimplantierter Emitterzone

Die Erfindung bezieht sich auf ein Verfahren zum Herstellen bipolarer Transistoren in integrierten Schaltungen. Die Emitterzonen dieser Transistoren werden durch Hochstrom-Ionenimplantation hergestellt, wobei dafür gesorgt wird, daß durch die Ionenimplantation verursachte Schäden und Verunreinigungen verhindert und insbesondere im Bereich des Emitter-Basis-Überganges zu Störungen führende Prozeßeinflüsse verhindert werden.

Der 1. Teil des Anspruchs 1 sowie die in den kennzeichnenden Teilen der Ansprüche 2 und 4 angegebenen Merkmale sind aus der Veröffentlichung »IBM Technical Disclosure Bulletin« Vol. 20, No. 11A, April 1978, Seiten 4351 und 4352 bekannt.

Es ist bereits bekannt, die Implantation von Ionen in ein Halbleitersubstrat durch eine aus einer Oxidschicht bestehende dünne Schutzschicht vorzunehmen. Ein solches Verfahren ist beispielsweise in der US-A-3 945 856 beschrieben. Die Schutzschicht hat eine Dicke von 10 bis 100 nm und bewirkt, daß in ihrem oberen Schichtbereich störende, bei der Ionenimplantation auftretende Verunreinigungen eingefangen werden. Bei der Ionenimplantation wird der obere Schichtbereich im allgemeinen zerstört. Dieser Schichtbereich wird vor dem dem eigentlichen Implantationsprozeß nachfolgenden Temperaturzyklus zum Eintreiben der implantierten Zone ab geätzt, so daß diese eingefangenen Verunreinigungen nicht in das Halbleitersubstrat eindiffundieren können.

Die Ionenimplantation von Emitterzonen in eine diffundierte Basiszone hat gegenüber einem Diffusionsprozeß den Vorteil, daß die Störstellenkonzentration innerhalb eines Bereiches von 1 bis 2% genau eingehalten werden kann, mit dem Ergebnis, daß genau definierte Parameter der in ihren Eigenschaften verbesserten Transistoren und eine höhere Ausbeute bei der Herstellung erzielt wird. Die Implantation der Emitterzone bringt jedoch auch eine Schwierigkeit mit sich, die darin besteht, daß im Bereich des Maskenfensters für die Emitterimplantation Überhänge bzw. Unterätzungen des Maskenmaterials auftreten und dadurch infolge der gerichteten Implantation eine sichere Passivierung des Emitter-Basis-Überganges verhindern. Durch die Unterätzung der passivierenden Maske wird der Emitter-Basis-Übergang an der Oberfläche des Halbleitersubstrats nicht abgedeckt, so daß sich ein Ausbeuteverlust einstellt. Die genannte Unterätzung tritt dann auf, wenn die Maske aus einer Doppelschicht von beispielsweise Siliciumnitrid und Siliciumoxid besteht. Es zeigt sich nämlich, daß beim Aufbringen der Siliciumoxidschicht diese im Bereich über der Kollektorzone schneller wächst als über dem Bereich der die Emitterzone aufnehmenden Basiszone. Das heißt also, die Siliciumoxidschicht ist im Bereich des zu bildenden Emitterfensters dünner als im Bereich der zu bildenden Kollektorkontaktfenster oder der Kontaktfenster zur Bildung von Schottky-Dioden im Bereich der Kollektorzone. Beim gleichzeitigen Ätzen der Fenster treten, da der Ätzprozeß sich nach der dickeren Schicht richten muß, im Bereich des Emitterfensters die beschriebene Unterätzung und die damit verbundenen Probleme auf.

Das Problem der Unterätzung ist beispielsweise in der Veröffentlichung »IBM Technical Disclosure Bulletin« unter dem Titel »Fabricating Ion Implated Regions in Semiconductors« in Vol. 19, No. 9, Februar 1977, Seiten 3407 bis 3408 und unter dem Titel »Implanted Emitter Process For Semiconductor Transistor« in Vol. 18, No. 7, Dezember 1975, Seiten 2177 bis 2178 beschrieben. In der letztgenannten Veröffentlichung wird das Unterätzen dadurch vermieden, daß die Oxidschicht im Bereich der Kollektorzone vor der Bildung der Maskenfenster entfernt und neu, mit verringerter Dicke aufgewachsen wird. Auch bei diesem Verfahren erreicht man keine gleichmäßigen Schichtdicken, so daß das Problem erhalten bleibt, wenn auch in verringertem Maße. In der erstgenannten Veröffentlichung wird eine Unterätzung dadurch vermieden, daß zum Ätzen der Oxidschicht ein Ätzmittel verwendet wird, das auch die darüberliegende Nitridschicht angreift. Auf diese Weise wird ein Überhängen der Nitridschicht zwar verhindert, jedoch auf Kosten einer Vergrößerung der Emitter- und Kontaktfenster. Es ist auch möglich, die Maskenfenster im Bereich der Oxidschicht durch reaktives Ionenätzen herzustellen. Da dieses Ätzverfahren in Bezug auf zu ätzende unterschiedliche Materialien nicht selektiv wirkt, muß bei unterschiedlicher Schichtdicke das Emitterfenster überätzt werden, um das Kollektorkontaktfenster sicher zu öffnen. Dabei kann auch die Halbleiteroberfläche im Bereich des Emitterfensters angegriffen werden, was zu späteren Feinschlüssen führen kann.

Hier will die Erfindung Abhilfe schaffen. Die Erfindung, wie sie in den Ansprüchen gekennzeichnet ist, löst die Aufgabe, ein Verfahren zum Herstellen bipolaren Transistoren mit ionenimplantierter Emitterzone anzugeben, bei dem in mit den Herstellungsverfahren diffundierter Strukturen kompatiblen Verfahrensschritten das Unterätzen der zur Implantation der Emitterzone verwendete doppelschichtigen Maske verhindert wird und bei dem die Anwendung einer Schutzschicht beim Implantationsprozeß möglich ist.

Beim erfindungsgemäßen Verfahren werden in einer maskierenden Schicht mit Hilfe einer Photolackschicht in einem ersten Ätzprozeß das Emitterfenster und das Basiskontaktfenster geöffnet. Im gleichen Ätzschiritt wird die Maske im Bereich des zu bildenden Kollektorkontaktfensters nur zu einem Teil ihrer dort höheren Gesamtdicke geätzt. Die Photolackschicht wird anschließend entfernt. Nach dem Aufbringen einer weiteren Photolackschicht, die das Emitterfenster und das Basiskontaktfenster abdeckt, wird das Maskenfenster für den Kollektorkontakt in einem zweiten Ätzschritt vollends durchgeätzt. Nach Entfernen der zweiten Photolackschicht wird zumindest im Bereich des Emitterfensters eine dünne Schutzschicht aufgebracht. Eine dritte Photolackschicht dient als Implantationsmaske und deckt das Basiskontaktfenster ab, während das Emitterfenster geöffnet bleibt. Schließlich erfolgt die Implantation der Emitterzone.

Durch das erfindungsgemäße Verfahren wird das schädliche Unterätzen bei doppelschichtigen bzw. das störende Überätzen bei einschichtigen Masken im Bereich des Emitterfensters verhindert. Es lassen sich Transistoren in hoher, definierter Qualität im Rahmen integrierter Schaltungen mit hoher Ausbeute verwirklichen.

Im folgenden wird die Erfindung anhand von lediglich einen Ausführungsweg darstellenden Zeichnungen näher erläutert.

Es zeigen

Fig. 1, 2 und 4 bis 7 Teilschnittansichten von integrierten Halbstrukturen in aufeinanderfolgenden Herstellungsstufen gemäß dem erfindungsgemäßen Verfahren und

Fig. 3 eine Teilschnittansicht einer integrierten Halbleiterstruktur, die das in erster Linie der Erfindung zugrundeliegende Problem der Passivierung des Emitter-Basis-Überganges verdeutlicht.

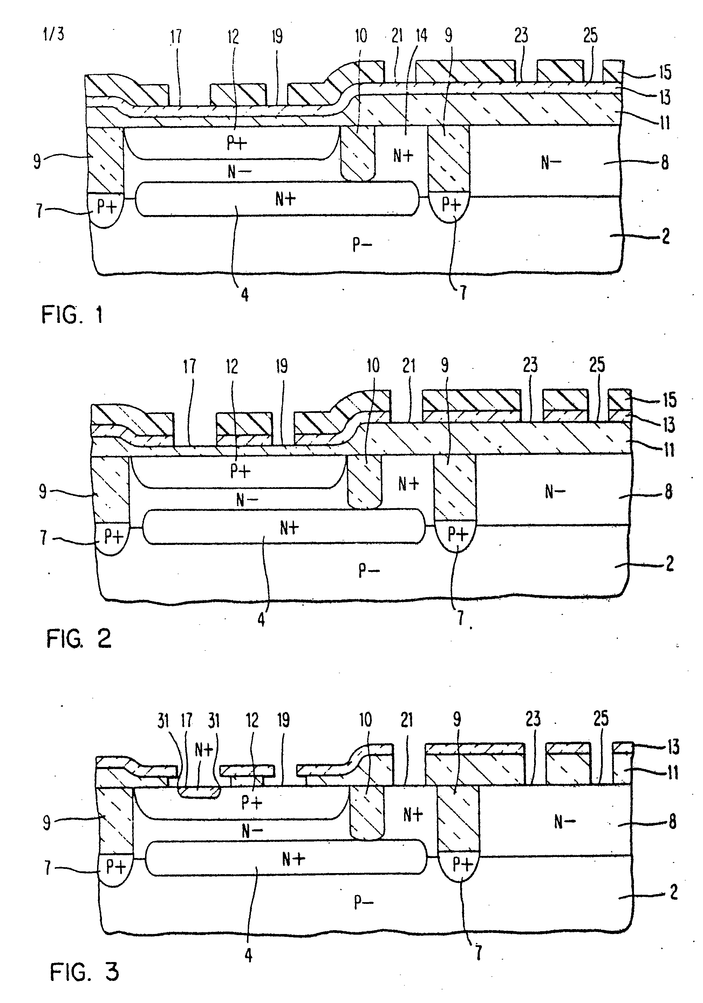

Die in Fig. 1 teilweise fertiggestellte integrierte Halbleiterstruktur umfaßt eine $N^-$-dotierte Epitaxieschicht 8, die auf ein $P^-$-Halbleitersubstrat 2 aus Silicium aufgebracht ist. Eine Subkollektorzone 4 und eine $P^+$-dotierte Isolationszone 7 sind in die die Kollektorzone eines Transistors bildende Epitaxieschicht 8 ausdiffundiert. Die Epitaxieschicht 8 weist vorzugsweise eine Dicke von etwa 2 μm oder weniger und eine Störstellenkonzentration von 2 bis $2,2 \times 10^{16}$ Atome/cm³ auf. Subkollektorzone 4 und Isolationszone 7 sind vorzugsweise in Standardprozessen durch Diffusion in das Halbleitersubstrat 2 hergestellt.

In der Epitaxieschicht 8 sind zusätzlich abgesenkte Oxid-Isolationszonen 9 und 10 eingebracht, die die verschiedenen Halbleiterbereiche der in der Epitaxieschicht zu bildenden Elemente isolieren. Im betrachteten Beispiel umfaßt der isolierte Bereich die $N^+$-dotierte Subkollektorzone 4 mit einer $N^+$-dotierten Kollektorkontaktierungszone 14 und eine P-dotierte Basiszone 12.

Auch die Herstellung der abgesenkten Oxidbereiche 9 und 10 erfolgt durch in der integrierten Halbleitertechnik übliche Standardprozesse, die nicht Gegenstand der Erfindung sind und deshalb nicht näher beschrieben werden.

Die Struktur ist mit einer Schicht aus Siliciumdioxid 11 und einer Schicht aus Siliciumnitrid 13 bedeckt. Die Dicke der Siliciumdioxidschicht ist über N-dotierten Bereichen, also über der Kollektorkontaktierungszone 14 und dem weiteren Bereich der $N^-$-dotierten Epitaxieschicht 8 größer (200 bis 360 nm) als über der P-dotierten Basiszone 12 (80 bis 200 nm). Die Ursache für diesen Dickenunterschied liegt dem unterschiedlich schnellen Oxidwachstum über den unterschiedlich dotierten Halbleiterbereichen bei der Bildung der Siliciumdioxidschicht 11. Die auf die Siliciumdioxidschicht 11 aufgebrachte Siliciumnitridschicht 13 weist eine Dicke von etwa 160 nm auf. Auf der Siliciumnitridschicht befindet sich eine Photolackschicht 15, die auf üblichem photolithographischem Wege hergestellte Fenster aufweist, in deren Bereich die Emitterzone 17, der Basiskontakt 19 und der Kollektorkontakt 21 eines zu verwirklichenden Transistors anzuordnen sind. Außerdem sind Fenster 23 und 25 für die Anode und die Kathode einer Schottky-Diode vorgesehen.

Die im Bereich dieser Fenster freigelegte Siliciumnitridschicht 13 wird dann bis zur Siliciumdioxidschicht 11 entweder durch ein Naßätzverfahren oder durch reaktives Ionenätzverfahren in einer $CF_4$ enthaltenden Atmosphäre geätzt, was in Fig. 2 dargestellt ist.

Der bis hierher beschriebene Verfahrensablauf ist konventionell. Der nächste üblicherweise folgende Schritt wäre nun, sämtliche N-Kontaktgebiete (Emitter, Kollektor und Kathode der Schottky-Diode) freizulegen, indem die Siliciumdioxidschicht 11 geätzt wird. Da die Siliciumdioxidschicht 11 Dickenunterschiede von etwa 120 nm aufweist, würde im Emitterfenster eine Überätzung stattfinden, bevor das Kollektorkontaktfenster und das Kathodenfenster der Schottky-Diode völlig freigeätzt wären. Dieses Überätzen der Siliciumoxidschicht im Bereich des Emitterfensters 17 führt zu dem in Fig. 3 dargestellten Überhang der Siliciumnitridschicht 13 in diesem Bereich. Wird der Emitter durch Diffusion hergestellt, so entsteht aus dieser Über- bzw. Unterätzung kein Problem, da sich die bei der Diffusion gebildete Emitterzone lateral ausbreitet und damit der Emitter-Basis-Übergang in den Bereich unterhalb der verbleibenden Siliciumdioxidschicht 11 verschoben wird. Wird dagegen der Emitter durch Ionenimplantation hergestellt, die in einer Richtung senkrecht zur Substratoberfläche ausgerichtet ist, ist die durch die Implantation gebildete Emitterzone direkt durch die Ausdehnung des kleineren Maskenfensters in der Siliciumnitridschicht 13 bestimmt und der Emitter-Basis-Übergang 31 gelangt nicht unter die passivierende Siliciumdioxidschicht 11. Diese Situation ist in Fig. 3 dargestellt.

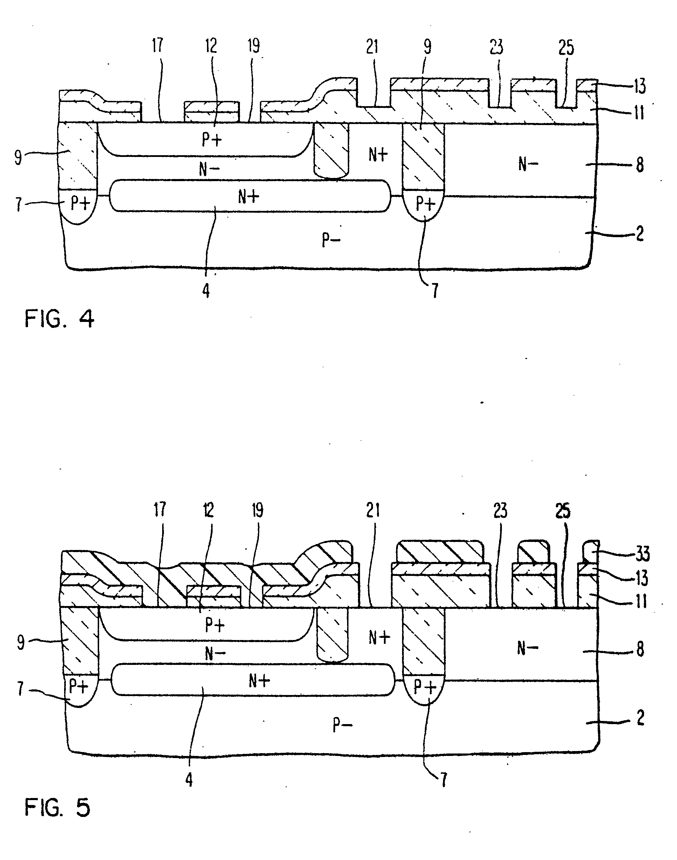

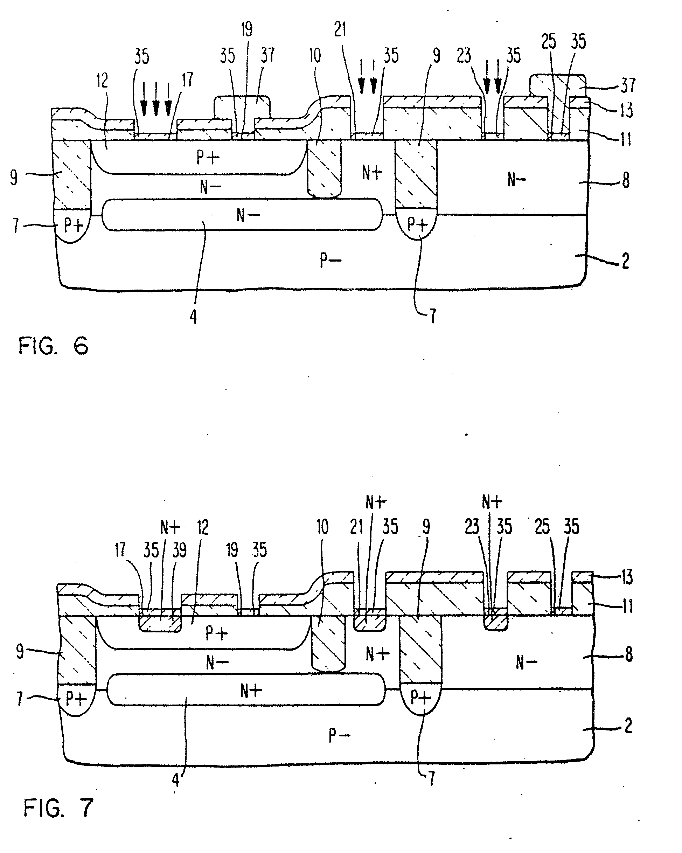

Beim erfindungsgemäßen Verfahren wird ausgehend von der Struktur gemäß Fig. 2 die erste Photolackschicht 15 nach dem Ätzen der Siliciumnitridschicht 13 auf der Oberfläche der Struktur belassen. Anschließend erfolgt das Ätzen der Siliciumdioxidschicht 11 in einem Naßätzverfahren in gepufferter Flußsäure. Dieser Ätzprozeß wird nur so lange fortgesetzt, bis das Emitterfenster 17 und das Basiskontaktfenster 19 bis zur Halbleiteroberfläche freigelegt sind. Dabei tritt kein Überätzen auf, die Siliciumdioxidschicht 11 im Bereich des Kollektorkontaktfensters 21 und der Schottky-Kontakte 23 und 25 ist jedoch nur zum Teil durchgeätzt. Die erste Photolackschicht 15 wird nunmehr entfernt. Man erhält die in Fig. 4 dargestellte Struktur. Wie in Fig. 5 dargestellt, wird nunmehr eine zweite Photolackschicht 33 aufgebracht und mit einem Muster ausgestattet, bei dem das Emitterfenster 17 und das Basiskontaktfenster 19 bedeckt und die Siliciumdioxidschicht im Bereich des Kollektorkontaktfensters 21 und der Schottky-Kontakte 23 und 25 freigelegt ist. Es folgt nun ein weiterer Ätzprozeß, bei dem der im Bereich der Fenster 21, 23 und 25 noch vorhandene Rest der Siliciumdioxidschicht 11 entfernt wird (Fig. 5). Dieser Ätzprozeß kann wiederum in gepufferter Flußsäure durchgeführt werden. Nunmehr wird auch die zweite Photolackschicht 33 entfernt und die Struktur gereinigt. Beim nächsten Verfahrensschritt wird eine dünne (20 bis 100 nm), vorzugsweise etwa 25 nm dicke Schutzschicht 35 aus Siliciumdioxid (Fig. 6) im Bereich der genannten Fenster aufgebracht. Diese Schutzschicht 35 wird vorzugsweise thermisch aufgewachsen.

Im nächsten Verfahrensschritt wird eine dritte Photolackmaske 37 aufgebracht, die lediglich das Emitterfenster 17, das Kollektorkontaktfenster 21 und das Kathodenkontaktfenster 23 der Schottky-Diode abdeckt (Fig. 6). Im nachfolgenden Ionenimplantationsprozeß werden die $N^+$-dotierten Zonen, also die Emitterzone 39, die Kollektorkontaktzone und die Kathodenkontaktzone der Schottky-Diode durch Implantation von beispielsweise Arsen oder Phosphor gebildet. Vorzugsweise wendet man einen Hochenergie-Implantationsprozeß mit einer Implantation von Arsen bei 50 kV (Bereich 40 bis 60 kV) bei einer Nenndosierung von $9,5 \times 10^{15}$ Atome/cm$^2$ mit einem Strom von etwa 2 mA (Bereich 1,8 bis 2,2 mA) an. Die Prozeßparameter werden so eingestellt, daß die gewünschten Charakteristiken erzeugt werden. Die Dosierung liegt dabei im Bereich von etwa $8,5 \times 10^{15}$ bis $10 \times 10^{15}$ Atome/cm$^2$. Die Durchführung der Ionenplantation erfordert etwa 2 bis 3 Minuten. Anschließend wird die dritte Photolackschicht 37 entfernt.

Die Schutzschicht 35 aus Siliciumdioxid verhindert bei der Ionenimplantation nicht nur Schäden an der Halbleiteroberfläche, sondern sie fängt auch einen beträchtlichen Teil implantierter Störstellen ein. Es ist deshalb von Bedeutung, die Dicke der Schutzschicht genau einzustellen (in einem Bereich von $\pm 10\%$), um eine parametrische Verteilung sicherzustellen. Die Schutzschicht nimmt in ihren obersten Schichtbereichen in einer Dicke von etwa 10 bis 15 nm auch metallische Verunreinigungen auf, die von der Implantationseinrichtung mitgeliefert werden. Um während der nachfolgenden, im Eintreiben der Emitterzone dienenden Wärmeschritt zu verhindern, daß entsprechende Schäden oder Verunreinigungen in das Halbleitermaterial wandern, wird der oberste Schichtbereich der Schutzschicht 35 in einer Dicke von 10 bis 15 nm durch Tauchätzen in gepufferter Flußsäure entfernt. Das Eintreiben der Emitterzone 39 in die Basiszone 12 erfolgt durch schrittweise Erhitzung der Struktur in einer Zeit-Temperaturfolge von 805°C während 10 Minuten, 1000°C während 69 bis 72 Minuten und 825°C während 10 Minuten. In diesem Verfahrensschritt verhindert der noch verbleibende Teil der Schutzschicht 35 das Ausdiffundieren der Störstellen aus dem Halbleitermaterial. Die Schutzschicht 35 wird nun wiederum durch Tauchätzen völlig entfernt. In anschließenden, nicht mehr dargestellten Verfahrensschritten werden die Kontakte und die leitenden Zwischenverbindungen in konventioneller Art hergestellt.

Das erfindungsgemäße Verfahren liefert die Transistoren mit verbesserten Charakteristiken und erhöhten, normalerweise durch Emitter-Kollektor-Leckströme begrenzten Ausbeuten. Gleichzeitig werden die durch die Ionenimplantation des Emitters gegenüber der Diffusion gegebenen Vorteile ausgenutzt.

## Patentansprüche

1. Verfahren zum Herstellen bipolarer Transistoren mit ionenimplantierter Emitterzone (39) innerhalb einer in einer Kollektorzone (8) liegenden Basiszone (12), unter Verwendung einer ein Emitterfenster (17), ein Basiskontaktfenster (19) und mindestens ein Kollektorkontaktfenster (21) aufweisenden Maske (11, 13), die im Bereich der Kollektorzone (8) eine größere Schichtdicke aufweist als im Bereich der Basiszone (12), dadurch gekennzeichnet, daß nach Aufbringen des Maskenmaterials (11, 13) mit Hilfe einer ersten Photolackmaske (15) gleichzeitig Emitter- und Basiskontaktfenster (17, 19) vollständig und das Kollektorkontaktfenster (21) nur teilweise das Maskenmaterial durchdringend gebildet werden (Fig. 4), daß nach Entfernung der ersten Photolackmaske (15) eine zweite, nur das Kollektorkontaktfenster (21) nicht bedeckende Photolackmaske (33) aufgebracht und das Kollektorkontaktfenster (21) vervollständigt wird (Fig. 5), daß nach Entfernung der zweiten Photolackschicht (33) eine dritte Photolackmaske (37) als Implantationsmaske aufgebracht wird, die das Emitterfenster (17) und eventuell vorhandene gleichartige weitere Fenster (23, 25) in der Maske (11, 13) freiläßt und daß schließlich die Ionenimplantation durchgeführt wird.

2. Verfahren nach Anspruch 1, dadurch gekennzeichnet, daß zusammen mit dem Kollektorkontaktfenster (21) und in einer der Herstellung des Kollektorkontaktfensters (21) entsprechenden Weise im Bereich der Kollektorzone (8) Kontaktfenster (23, 25) für Schottky-Dioden in der Maske (11, 13) erzeugt werden.

3. Verfahren nach Anspruch 1 oder 2, dadurch gekennzeichnet, daß nach Entfernung der zweiten Photolackmaske (33) mindestens im Bereich des Emitterfensters (17) eine während des nachfolgenden Ionenimplantationsprozesses als Schutzschicht (35) diendende, dünne Schicht aufgebracht wird.

4. Verfahren nach Anspruch 1, 2 oder 3, dadurch gekennzeichnet, daß die Maske aus einer auf den Halbleiterkörper aufgebrachten Siliciumdioxidschicht (11) und einer darüberliegenden Siliciumnitridschicht (13) zusammengesetzt ist, wobei die Siliciumdioxidschicht (11) über der Kollektorzone (8) dicker ist als über der Basiszone (12).

5. Verfahren nach Anspruch 4, dadurch gekennzeichnet, daß die Fenster im Bereich der Siliciumnitridschicht (13) durch reaktives Ionenätzen und im Bereich der Siliciumdioxidschicht (11) durch Naßätzen gebildet werden.

6. Verfahren nach Anspruch 3, dadurch gekennzeichnet, daß die Schutzschicht (35) aus Siliciumdioxid besteht und eine Dicke im Bereich von 20 bis 100 nm, vorzugsweise eine Dicke von etwa 25 nm aufweist.

7. Verfahren nach Anspruch 3 und 6, dadurch gekennzeichnet, daß nach der Ionenimplantation der obere Bereich der Schutzschicht (35) entfernt und dann der zum Eintreiben der implantierten Zone erforderliche Erwärmungsprozeß durchgeführt wird.

8. Verfahren nach den Ansprüchen 1 bis 7, dadurch gekennzeichnet, daß die Ionenimplantation mit einer Energie von 40 bis 60 kV, einer Stromstärke von 1,8 bis 2,2 mA und während einer solchen Dauer erfolgt, daß eine Dosierung von etwa $8,5 \times 10^{15}$ bis $10 \times 10^{15}$ Atome/cm$^2$ erzielt wird.

9. Verfahren nach Anspruch 8, dadurch gekennzeichnet, daß die Energie etwa 50 kV, der Strom etwa 2 mA und die Dosierung etwa $9,5 \times 10^{15}$ Arsenatome/cm$^2$ beträgt.

## Claims

1. Method of making bipolar transistors with ion implanted emitter zone (39) within a base zone (12) in a collector zone (8), using a mask (11, 13) which contains an emitter window (17), a base contact window (19), and at least one collector contact window (21) and which in the region of the collector zone (8) is of a greater layer thickness than in the region of the base zone (12), characterized in that following the application of the mask material (11, 13) emitter and base contact windows (17, 19) and the collector contact window (21) are made simultanously by means of a first photoresist mask (15), with the emitter and base contact windows going fully and the collector contact window only partially through the mask material (Figure 4), that after the removal of the first photoresist mask (15) a second photoresist mask (33) not covering only the collector contact window (21) is applied and the collector contact window (21) is completed (Figure 5), that after the removal of the second photoresist mask (33) a third photoresist mask (37) is applied as an implantation mask which leaves uncovered the emitter window (17) and possibly existing similar further windows (23, 25) in the mask (11, 13), and that finally the ion implantation is carried out.

2. Method as claimed in claim 1, characterized in that together with the collector contact window (21) and in a manner corresponding to the production of the collector contact window (21) contact windows (23, 25) are made in the collector zone (8) region for Schottkydiodes in the mask (11, 13).

3. Method as claimed in claim 1 or 2, characterized in that after the removal of the second photoresist mask (33) a thin layer which in the subsequent ion implantation process is used as a protective layer (35) is applied at least in the area of the emitter window (17).

4. Method as claimed in any one of claims 1, 2 or 3, characterized in that the mask is composed of a silicon dioxide layer (11) applied on the semiconductor body, and of a superimposed silicon nitride layer (13), the silicon dioxide layer (11) over the collector region (8) being thicker than over the base region (12).

5. Method as claimed in claim 4, characterized in that the windows in the region of the silicon nitride layer (13) are made by reactive ion etching and in the region of the silicon dioxide layer (11) by wet etching.

6. Method as claimed in claim 3, characterized in that the protective layer (35) consists of silicon dioxide and has a thickness between 20 and 100 nm, preferably a thickness of approximately 25 nm.

7. Method as claimed in claims 3 and 6, characterized in that following ion implantation the upper range of the protective layer (35) is removed, and subsequently the heating process required for driving-in the implanted zone is carried out.

8. Method as claimed in any one of claims 1 to 7, characterized in that ion implantation is effected with an energy of 40 to 60 kV, a current of 1.8 to 2.2 mA and that it is effected during such a period that a dosage of approximately $8.5 \times 10^{15}$ to $10 \times 10^{15}$ atoms/cm$^2$ is achieved.

9. Method as claimed in claim 8, characterized in that the energy is approximately 50 kV, the current approximately 2 mA, and the dosage approximately $9.5 \times 10^{15}$ arsenic atoms/cm$^2$.

## Revendications

1. Procédé de fabrication de transistors bipolaires comportant une zone d'émetteur implantée d'ions (39) disposée à l'intérieur d'une zone de base (12) elle-même disposée dans une zone de collecteur (8), en utilisant un masque (11, 13) qui comporte: une fenêtre d'émetteur (17), une fenêtre de contact de base (19), et au moins une fenêtre de contact de collecteur (21) et qui, dans la région de la zone de collecteur (8), présente une épaisseur de couche supérieure à celle de la région de la zone de base (12), caractérisé en ce que, à la suite de l'application du matériau de masquage (11, 13), les fenêtres de contact d'émetteur et de base (17, 19) et la fenêtre de contact de collecteur (21) sont réalisées simultanément au moyen d'un premier masque de photorésist (15), les fenêtres de contact d'émetteur et de base traversent entièrement et la fenêtre de contact de collecteur ne traversent que partiellement, le matériau de masquage (figure 4), en ce que, après le retrait du premier masque de photorésist (15), un deuxième masque de photorésist (33) ne recouvrant pas seulement la fenêtre de contact de collecteur (21), est appliqué et la fenêtre de contact de collecteur (21) est achevée (figure 5), en ce que, après le retrait du deuxième masque de photorésist (33), un troisième masque de photorésist (37) est appliqué comme un masque d'implantation qui laisse à découvert la fenêtre d'émetteur (17) et d'autres fenêtres similaires pouvant exister (23, 25) dans le masque (11, 13) et en ce que, finalement, l'implantation d'ions est exécutée.

2. Procédé selon la revendication 1, caractérisé en ce que, ensemble avec la fenêtre de contact de collecteur (21) et d'une manière correspondant à la réalisation de cette fenêtre, les fenêtres de contact (23, 25) sont formées dans la région de la zone de collecteur (8) dans le masque (11, 13), pour la réalisation ultérieure de diodes de Schottky dans la région de zone de collecteur (8).

3. Procédé selon la revendication 1 ou 2, caractérisé en ce que, après le retrait du deuxième masque de photorésist (33), une couche mince qui, au cours de l'exécution de l'implantation d'ions suivante, sera utilisée comme une couche de protection (35), est appliquée au moins dans la zone de la fenêtre d'émetteur (17).

4. Procédé selon l'une quelconque des revendications 1, 2 ou 3, caractérisé en ce que le masque est composé d'une couche de dioxyde de silicium (11) disposée sur le corps semiconducteur, et d'une couche de nitrure de silicium superposée (13), la couche de dioxyde de silicium (11) étant plus épaisse sur la région de collecteur (8) que sur la région de base (12).

5. Procédé selon la revendication 4 caractérisé en ce que les fenêtres dans la région de la couche de nitrure de silicium (13) sont réalisées par décapage par ions réactifs et celles dans la région de la couche de dioxyde de silicium (11), par décapage humide.

6. Procédé selon la revendication 3, caractérisé en ce que la couche de protection (35) est composée de dioxyde de silicium et a une épaisseur comprise entre 20 et 100 nm, de préférence une épaisseur d'approximativement 25 nm.

7. Procédé selon les revendications 3 et 6, caractérisé en ce que, à la suite de l'implantation d'ions, la partie supérieure de la couche de protection (35) est retirée, et ensuite, l'étape de recuit nécessaire à l'implantation d'ions, est exécuté.

8. Procédé selon l'une quelconque des revendications 1 à 7 caractérisé en ce que l'implantation d'ions est effectuée avec une énergie de 40 à 60 kV, un courant de 1,8 à 2,2 mA et pendant une période telle qu'une dose approximative de $8,5 \times 10^{15}$ à $10 \times 10^{15}$ atomes/cm² est obtenue.

9. Procédé selon la revendication 8 caractérisé en ce que l'énergie est approximativement de 50 kV, le courant approximativement 2 mA et la dose approximativement $9,5 \times 10^{15}$ atomes d'arsenic au cm².

1/3

FIG. 1

FIG. 2

FIG. 3

FIG. 4

FIG. 5

FIG. 6

FIG. 7